# EUROPEAN PATENT SPECIFICATION

(11) **EP 1 976 111 B1**
(45) Date of publication and mention of the grant of the patent: **20.10.2010**
(21) Application number: 07116341.4
(22) Date of filing: 13.09.2007
(51) Int. Cl.: H03F 1/30, H03G 3/34

(54) **Pop-noise prevention method and apparatus**
Verfahren und Vorrichtung zur Verhinderung von Einschaltgeräuschen
Procédé et appareil de prévention de bruit de type pop

(30) Priority: 30.03.2007 TR 200702096
(43) Date of publication of application: 01.10.2008
(73) Proprietor: Vestel Elektronik Sanayi ve Ticaret A.S., 45030 Manisa (TR)
(72) Inventor: Yilmazlar, Ismail, 45030, MANISA (TR)
(74) Representative: Cayli, Hülya

(56) References cited:
- EP-A- 0 899 869
- JP-A- 59 154 805

## Description

### Technical Field

This invention relates to an apparatus and method, in order to solve the pop-noise occurring at the power-up interval (when single supply-asymmetric output audio amplifier is used), by controlling an output from an amplifier used in audio power management system during a powering sequence.

### Prior Art

The presence of integral audio amplifiers and loudspeakers presents certain specific problems associated with the cycling of power in a multimedia device. Typically, the sudden application of power to the audio system produces extraneous and annoying sounds usually characterized as clicks and pops. The clicks and pops can be caused by the exposure of the audio amplifier to the operation points that are outside of the recommended operating range of the amplifier. Moreover, audio clicks and pops can be introduced when the audio input to the audio amplifier becomes unstable before power has been removed from the audio amplifier assembly. In either case, the audio amplifier generates one or more annoying pops or clicks through speakers. It is therefore desirable to eliminate the noisy sounds when power is cycled to the multimedia system.

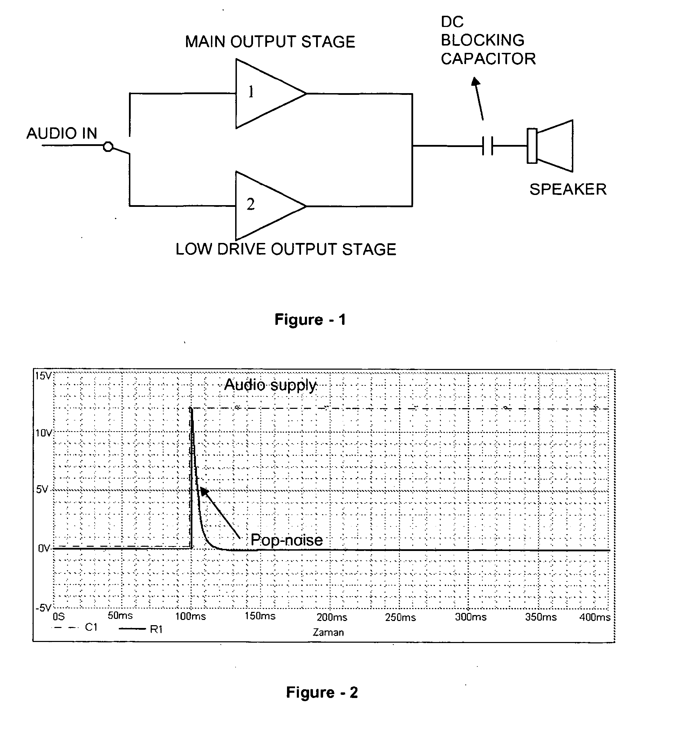

A solution for pop-noise prevention typically used in a standard audio amplifier circuit is realized by charging the DC blocking capacitor with an increased rising time. In Figure.1 this charging process is realized by employing a low gain amplifier (2) in order not to hear the click-on noise. As soon as the charging value reaches to the desired voltage level, then the audio input is switched to the main amplifier stage (1). The detailed explanation of this kind of solution can be found in US2006/0182265.

Another method to solve the "click on" noise problem is to use symmetric output audio amplifier. In this solution, there is no need of a DC blocking capacitor at the output, since there is no DC value influence at the output, and consequently no pop noise is available at the speaker. The detailed explanation of this kind of solution can be found in WO95/17040.

Japanese patent application with publication number JP 59 154805 discloses a system for preventing the generation of pop noise by stopping the operation of an amplifier for a prescribed time, after application of power switch so as to charge a bypass capacitor to a potential slightly higher than a bias potential. This system enables charging of output bypass capacitor (20) slowly.

Also, EP 0 899 869 discloses the operating point setting method. The method has a short-term bias voltage applied to the control input of the transistor stage prior to switching in of the supply voltage, with the operating point determined from a rectified input signal upon application of the supply of the transistor stage, under control of a controlled switch, with a second controlled switch used for switching in the supply voltage after a given delay.

The main disadvantage related to the first prior-art solution is that it is necessary to use more than one operational amplifier, which makes the circuit more complicated. It's also very dependent and sensitive to components (12, 14, 16, 28) used to supply a negative bias. For the second prior-art example, instead, it is needed a special operational amplifier, namely a symmetric output amplifier: these are though more difficult to implement, when compared to Class-AB audio amplifiers which have single supply and asymmetric output.

Another problem associated to both prior-art examples is the possible transient noises that are generated because of power supply of amplifiers.

Therefore there is the need for an apparatus in order to provide a power supply voltage to an input of an output amplifier to receive an input signal and have its output coupled to a load for providing an audible output, responsive to a different signal between the input signal and the bias voltage that address these and other related and unrelated problems.

This invention solves all these mentioned problems.

Various objects, features and advantages of the present invention will become apparent to those skilled in the art upon reading the following detailed description, when taken in conjunction with the accompanying drawings.

### Object of the Invention

The aim of the present invention is to solve the pop noise problem occurring at the power up interval, by preventing the immediate input voltage rising by slowly increasing the supply voltage of the amplifier in order to control an output from an amplifier used in audio power management system during a powering sequence.

### Brief Description of the Drawings

Figure.1 Block diagram of the Standard System
Figure.2 Pop-Noise in the Simulation
Figure.3 Block Diagram of Invention
Figure.4 Circuit Diagram of the Invention Comprising On-Off Control Switch Circuit (second control circuit) with Pop-Noise Prevention Circuit (first control circuit).
Figure.5 Pop-Noise Prevention Circuit (First Control Circuit)
Figure.6 Simulation Results of Invention

### Detailed Description of the Invention

In order to prevent power consumption at the stand-by mode, a low resistive switch (like a MOSFET) should be used to supply the audio amplifier. At the system power up, a rising edge of supply voltage is noticed at the speaker, because the DC blocking capacitor can't filter this rising edge in a short time period. This causes the so called "click on" noise, audible particularly if the audio amplifier has single supply and asymmetric output.

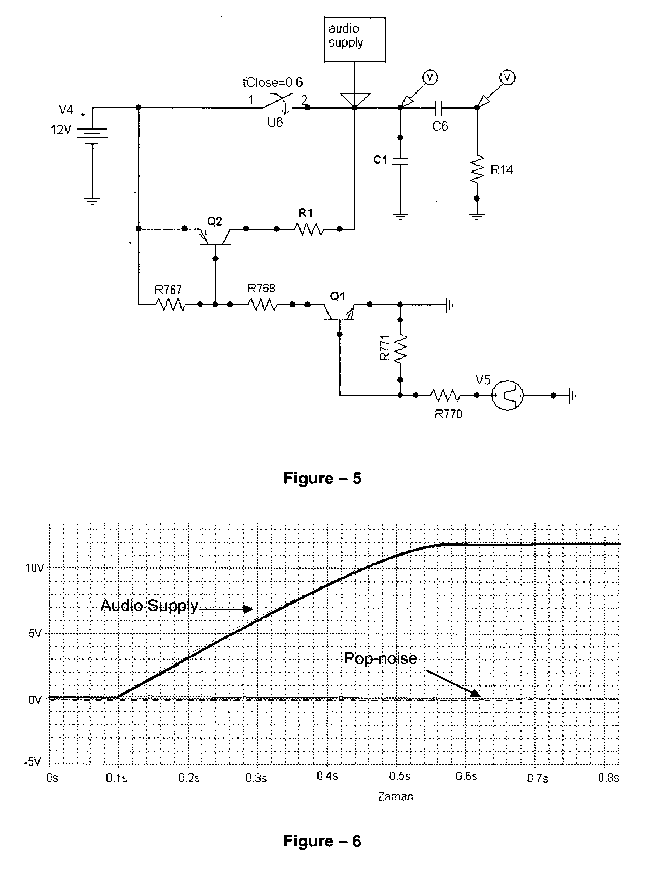

In order to solve the problem of the rising edge of the supply voltage it is introduced an additional circuit (as seen in figure 5) to control this supply rise. The click-on noise that would appear without the additional circuit is depicted in Figure.2.

The solution is to **slow down the amplifier's supply voltage rising time** with a voltage rising control circuit (pop-noise prevention circuit) shown in Figure.5.

It follows a preferred embodiment.

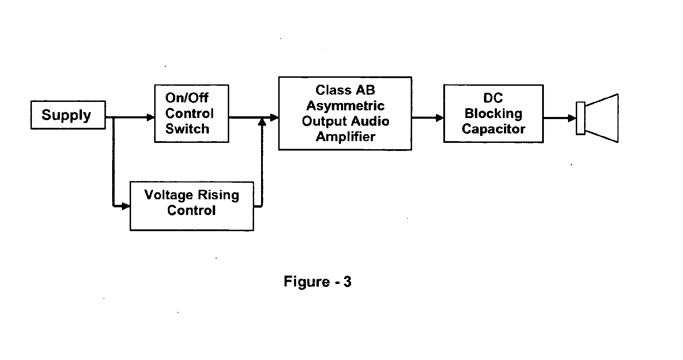

At the start up, current flows through the voltage rising control block (in figure 3), until the supply voltage of the audio amplifier reaches its steady state value, and then the current flows through the control switch. Instead of charging the DC blocking capacitor, in this method the supply voltage of audio amplifier is increased slowly. By doing so, possible transient noises can be avoided at the speaker output. The block diagram of the system is shown in Figure.3.

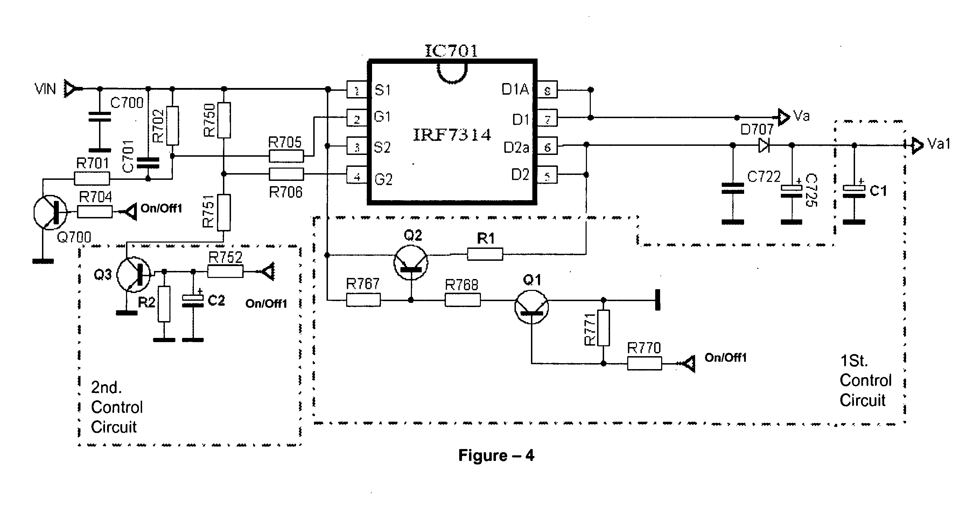

The audio amplifier is supplied over (IC701), as shown in Figure.4 (In figure 4 the circuit comprising IC701 forms the control switch). Turn ON/OFF operation is controlled by a switch. Control pin named as ON/OFF1 is connected to the (R752). If the ON/OFF1 voltage is 0V, (Q3) is not conducting so Vgs voltage of (IC701) is equal to 0V and (IC701) is OFF (and consequently (VA1) voltage, which is the supply voltage for audio amplifier, is also equal to 0V). To operate the audio amplifier, a microcontroller sends a high logic signal so the ON/OFF1 pin becomes 3.3V, (C2) slowly charges to 0.6 V. The time needed for (C2) to charge can be adjusted by adapting the values of (R752) and (C2). Once the voltage level reaches 0.6V at the base of (Q3), Vgs voltage of the Mosfet (IC701) reaches -6V, so (IC701) becomes on (VA1 is equal to 12V). During the period needed by (C2) to charge to 0.6V, (IC701) is OFF, but (Q2) is conducting because (Q1) starts conduction earlier than the (Q3) when a high logic signal (control signal) is applied. So the amplifier supply voltage capacitor is charged to the input voltage over (R1). A diode (D707) is placed at the output of the power supply to protect the first control circuit in case of any early tum-on of power switch (IC701).

The charge rising time can be obviously adjusted by varying the value of this resistor (R1), so that no sharp rising edge reaches the speaker.

In Figure.5; U6 denotes the main switch which controls audio supply voltage. V5 denotes the control signal, whereas R14 represents the speaker resistance and C1 the audio supply capacitance.

The simulation (shown in Fig. 6) starts at 0 sec. U6 starts conduction at 0.6 sec. V5 sends high logic signal at 0.1sec. Between 0.1-0.6 sec. Q2 conducts and C1 charges over R1. Charging time can be adjusted by adjusting R1. Once C1 is charged to the supply voltage, U6 starts conduction so no current flowing available over R1.

As it is possible to notice from the simulation results shown in Figure.6, audio supply voltage increases slowly in time, contrary to the supply voltage rise, shown in Figure.2. This smooth transition in Figure.6 prevents pop-noise, which was instead present in the case shown in Figure.2.

By using the additional control circuit according to the invention there is no need to use symmetric output amplifiers in an audio amplification application in order to solve pop-noise problem, since symmetric output audio amplifiers are more complicated to realize compared to asymmetric output audio amplifiers. Solving the pop-noise problem by using more than one amplifier is also not very convenient to implement.

Consequently, the invention advantageously solves the problem with just one amplifier and eliminates the transient noise during the dynamic phase of the amplifier supplying voltage is eliminated.

## Claims

1. An apparatus for providing a power supply voltage to a power input of an output amplifier, the output amplifier for receiving an input signal and having its output coupled to a load for providing an audible output comprising:
• a first capacitor (C1) coupled to the power input of said output amplifier,
• a first resistor (R1), coupled to said first capacitor (C1), through which a current will flow to charge said first capacitor (C1),
• a power supply for supplying power to said output amplifier
• a first control circuit, comprising said first resistor (R1) coupled to said first capacitor (C1) via a diode (D707), a second transistor (Q2) which is controlled by a first transistor (Q1) controlled by a control pin (ON/OFF1), to charge said first capacitor (C1) in a first period immediately after the power on of said output amplifier,
• a power switch (IC701) coupled between said power supply and said power input of said output amplifier, said power switch (IC701) transfers power from said power supply to said power input of said output amplifier,
• a second control circuit coupled to said power switch (IC701) that switches on the said power switch with a certain delay over the power on of said output amplifier,
said first control circuit further comprises;
• said first transistor (Q1) is adapted to be biased via a second resistor (R770) and a third resistor (R771) wherein said first transistor (Q1) gets in conduction mode without any delay as a high logic signal is applied to said control pin (ON/OFF1),
• said second transistor (Q2) connected with said first transistor (Q1) via a resistor set between the collector of the said first transistor and the base of said second transistor
and said second control circuit further comprises a third transistor (Q3) wherein a second capacitor (C2) is connected between said third transistor's (Q3) base and emitter and turning on of said third transistor (Q3) by applying said high logic signal to said control pin (ON/OFF1), is delayed.

2. An apparatus according to claim 1, wherein said output amplifier is a class AB amplifier.

3. Method for providing a power supply voltage to a power input of an output amplifier, the output amplifier configured for receiving an input signal and having its output coupled to a load for providing an audible output comprising:
• first charging a first capacitor (C1) coupled to said power input of said output amplifier,
• said first capacitor (C1) being charged via a first resistor (R1) through which a current will flow to charge said first capacitor (C1),
• using a first control circuit , comprising said first resistor (R1) coupled to said first capacitor (C1) via a diode (D707) and a second transistor (Q2) controlled by a first transistor (Q1) controlled by a control pin (ON/OFF1), to charge said first capacitor (C1) in a first period immediately after the power on of said output amplifier
• using a power supply for supplying power to said output amplifier,
• coupling a power switch (IC701) between said power supply and said power input of said amplifier, said power switch (IC701) enabling power to be transferred only from said power supply to said power input of said output amplifier,
• coupling said power switch (IC701) to a second control circuit that switches on said power switch (IC701) with a certain delay over the power on of said output amplifier
said method further comprises the steps of;
• applying a high logic signal to said control pin (ON/OFF1) and putting said first transistor (Q1) of said first control circuit in conduction mode without any delay using a second resistor (R770) and a third resistor (R771) and connecting a second transistor (Q2) with said first transistor (Q1) via a resistor set between the collector of said first transistor (Q1) and the base of said second transistor (Q2);
• said first resistor (R1), coupled to said first capacitor (C1) coupled to the load, is connected to the collector of said second transistor (Q2) and said first capacitor (C1) is charged and
a second capacitor (C2) is connected between base and emitter of a third transistor (Q3) in said second control circuit, wherein turning on of said third transistor (Q3) by applying said high logic signal to said control pin (ON/OFF1) is delayed.

## Patentansprüche

1. Vorrichtung zum Bereitstellen einer Stromversorgungsspannung an einen Leistungseingang eines Ausgangsverstärkers, wobei der Ausgangsverstärker, um ein Eingangssignal zu empfangen und seinen Ausgang zur Bereitstellung eines akustischen Ausgangs mit einem Verbraucher gekoppelt zu haben, umfasst:
• einen ersten Kondensator (C1), der mit dem Leistungseingang des Ausgangsverstärkers gekoppelt ist,
• einen mit dem ersten Kondensator (C1) gekoppelten ersten Widerstand (R1), durch den ein Strom fließt, um den ersten Kondensator (C1) zu laden,
• eine Stromversorgung, um den Ausgangsverstärker mit Strom zu versorgen,
• einen ersten Regelkreis, der den über eine Diode (D707) mit dem ersten Kondensator (C1) gekoppelten ersten Widerstand (R1) umfasst, einen zweiten Transistor (Q2), der von einem durch einen Steuerpin (ON/OFF1) gesteuerten ersten Transistor (Q1) gesteuert wird, um den ersten Kondensator (C1) in einem ersten Zeitraum unmittelbar nach dem Einschalten des Ausgangsverstärkers zu laden,
• einen Leistungsschalter (IC701), der zwischen der Stromversorgung und dem Leistungseingang des Ausgangsverstärkers angeschlossen ist, wobei der Leistungsschalter (IC 701) Strom aus der Stromversorgung an den Leistungseingang des Ausgangsverstärkers überträgt,
• einen mit dem Leistungsschalter (IC701) gekoppelten zweiten Regelkreis, der den Leistungsschalter mit einer bestimmten Verzögerung in Bezug auf das Einschalten des Ausgangsverstärkers einschaltet,
wobei der erste Regelkreis darüber hinaus umfasst:
• den ersten Transistor (Q1), der dazu ausgelegt ist, über einen zweiten Widerstand (R770) und einen dritten Widerstand (R771) vorgespannt zu werden, wobei der erste Transistor (Q1) ohne irgendeine Verzögerung in die Leitungsbetriebsart eintritt, wenn ein hohes logisches Signal an den ersten Steuerpin (ON/OFF1) angelegt wird,
• den zweiten Transistor (Q2), der über einen Widerstand, der zwischen dem Kollektor des ersten Transistors und der Basis des zweiten Transistors eingesetzt ist, mit dem ersten Transistor (Q1) verbunden ist,
und der zweite Regelkreis darüber hinaus einen dritten Transistor (Q3) umfasst, wobei ein zweiter Kondensator (C2) zwischen Basis und Emitter des dritten Transistors (Q3) angeschlossen ist, und das Einschalten des dritten Transistors (Q3), indem das hohe logische Signal an den Steuerpin (ON/OFF1) angelegt wird, verzögert wird.

2. Vorrichtung nach Anspruch 1, wobei der Ausgangsverstärker ein Verstärker der Klasse AB ist.

3. Verfahren zum Bereitstellen einer Stromversorgungsspannung an einen Leistungseingang eines Ausgangsverstärkers, wobei der Ausgangsverstärker dazu ausgelegt ist, ein Eingangssignal zu empfangen und seinen Ausgang zur Bereitstellung eines akustischen Ausgangs mit einem Verbraucher gekoppelt zu haben, Folgendes umfassend:
• zunächst Laden eines ersten Kondensators (C1), der mit dem Leistungseingang des Ausgangsverstärkers gekoppelt ist,
• wobei der erste Kondensator (C1) über einen ersten Widerstand (R1) geladen wird, durch den ein Strom fließt, um den ersten Kondensator (C1) zu laden,
• Verwenden eines ersten Regelkreises, der den über eine Diode (D707) mit dem ersten Kondensator (C1) gekoppelten ersten Widerstand (R1) umfasst, und einen zweiten Transistor (Q2), der von einem durch einen Steuerpin (ON/OFF1) gesteuerten ersten Transistor (Q1) gesteuert wird, um den ersten Kondensator (C1) in einem ersten Zeitraum unmittelbar nach dem Einschalten des Ausgangsverstärkers zu laden,
• Verwenden einer Stromversorgung, um den Ausgangsverstärker mit Strom zu versorgen,
• Anschließen eines Leistungsschalters (IC701)zwischen der Stromversorgung und dem Leistungseingang des Ausgangsverstärkers, wobei der Leistungsschalter (IC701) ermöglicht, dass Strom nur aus der Stromversorgung an den Leistungseingang des Ausgangsverstärkers übertragen wird,
• Koppeln des Leistungsschalters (IC701) mit einem zweiten Regelkreis, der den Leistungsschalter (IC701) mit einer bestimmten Verzögerung in Bezug auf das Einschalten des Ausgangsverstärkers einschaltet,
wobei das Verfahren darüber hinaus die folgenden Schritte umfasst:
• Anlegen eines hohen logischen Signals an den Steuerpin (ON/OFF1) und Versetzen des ersten Transistors (Q1) des ersten Regelkreises ohne irgendeine Verzögerung in die Leitungsbetriebsart unter Verwendung eines zweiten Widerstands (R770) und eines dritten Widerstands (R771), und Verbinden eines zweiten Transistors (Q2) mit dem ersten Transistor (Q1) über einen Widerstand, der zwischen dem Kollektor des ersten Transistors (Q1) und der Basis des zweiten Transistors (Q2) eingesetzt ist;
• wobei der erste Widerstand (R1), der mit dem ersten, mit dem Verbraucher gekoppelten Kondensator (C1) gekoppelt ist, mit dem Kollektor des zweiten Transistors (Q2) gekoppelt wird, und der erste Kondensator (C1) geladen wird, und
ein zweiter Kondensator (C2) zwischen Basis und Emitter eines dritten Transistors (Q3) im zweiten Regelkreis angeschlossen wird, wobei das Einschalten des dritten Transistors (Q3), indem das hohe logische Signal an den Steuerpin (ON/OFF1) angelegt wird, verzögert wird.

## Revendications

1. Appareil adapté pour fournir une tension d'alimentation à une entrée de puissance d'un amplificateur de sortie, l'amplificateur de sortie étant configuré de façon à recevoir un signal d'entrée et ayant sa sortie couplée à une charge pour fournir une sortie audible, l'appareil comprenant :
• un premier condensateur (C1) qui est couplé à l'entrée de puissance dudit amplificateur de sortie ;
• une première résistance (R1), qui est couplée au dit premier condensateur (C1) et à travers laquelle un courant circule pour charger ledit premier condensateur (C1) ;
• un bloc de fourniture de puissance pour fournir de la puissance au dit amplificateur de sortie ;
• un premier circuit de commande, comprenant ladite première résistance (R1) qui est couplée au dit premier condensateur (C1) par l'intermédiaire d'une diode (D707), un deuxième transistor (Q2) qui est contrôlé par un premier transistor (Q1) lui-même contrôlé par une broche de contrôle (ON/OFF1), pour charger ledit premier condensateur (C1) au cours d'une première période immédiatement consécutive à la mise en route dudit amplificateur de sortie ;
• un commutateur de puissance (IC701) qui est couplé entre ledit bloc de fourniture de puissance et ladite entrée de puissance dudit amplificateur de sortie, ledit commutateur de puissance (IC701) transférant la puissance dudit bloc de fourniture de puissance à ladite entrée de puissance dudit amplificateur de sortie ;
• un deuxième circuit de commande qui est couplé au dit commutateur de puissance (IC701) et qui met en route ledit commutateur de puissance avec un certain retard par rapport à la mise en route dudit amplificateur de sortie ;
ledit premier circuit de commande comprenant par ailleurs :
• ledit transistor (Q1), qui est adapté pour être polarisé par l'intermédiaire d'une deuxième résistance (R770) et une troisième résistance (R771), dans lequel ledit premier transistor (Q1) passe en mode conduction sans retard au moment où un signal logique fort est appliqué sur ladite broche de contrôle (ON/OFF1) ;
• ledit deuxième transistor (Q2), qui est connecté au dit premier transistor (Q1) par l'intermédiaire d'une résistance placée entre le collecteur dudit premier transistor et la base dudit deuxième transistor ;
et ledit deuxième circuit de commande comprend par ailleurs un troisième transistor (Q3), dans lequel un deuxième condensateur (C2) est connecté entre la base dudit troisième transistor (Q3) et un émetteur, et la mise en route dudit troisième transistor (Q3) par application dudit signal logique fort sur ladite broche de contrôle (ON/OFF1), est retardée.

2. Appareil selon la revendication 1, dans lequel ledit amplificateur de sortie est un amplificateur de catégorie AB.

3. Procédé adapté pour fournir une tension d'alimentation à une entrée de puissance d'un amplificateur de sortie, l'amplificateur de sortie étant configuré de façon à recevoir un signal d'entrée et ayant sa sortie couplée à une charge pour fournir une sortie audible, le procédé consistant :
• à charger tout d'abord un premier condensateur (C1) couplé à l'entrée de puissance dudit amplificateur de sortie ;
• ledit premier condensateur (C1) étant chargé par l'intermédiaire d'une première résistance (R1) à travers laquelle un courant circule pour charger ledit premier condensateur (C1) ;
• à utiliser un premier circuit de commande, comprenant ladite première résistance (R1) qui est couplée au dit premier condensateur (C1) par l'intermédiaire d'une diode (D707), et un deuxième transistor (Q2) qui est contrôlé par un premier transistor (Q1) lui-même contrôlé par une broche de contrôle (ON/OFF1), pour charger ledit premier condensateur (C1) au cours d'une première période immédiatement consécutive à la mise en route dudit amplificateur de sortie ;
• à utiliser un bloc de fourniture de puissance pour fournir de la puissance au dit amplificateur de sortie ;
• à coupler un commutateur de puissance (IC701) qui est couplé entre ledit bloc de fourniture de puissance et ladite entrée de puissance dudit amplificateur, ledit commutateur de puissance (IC701) permettant à la puissance d'être transférée uniquement dudit bloc de fourniture de puissance à ladite entrée de puissance dudit amplificateur de sortie ;
• à coupler ledit commutateur de puissance (IC701) à un deuxième circuit de commande qui met en route ledit commutateur de puissance (IC701) avec un certain retard par rapport à la mise en route dudit amplificateur de sortie ;
ledit procédé comprenant par ailleurs les étapes consistant :
• à appliquer un signal logique fort sur ladite broche de contrôle (ON/OFF1) et à amener ledit premier transistor (Q1) dudit premier circuit de commande en mode conduction sans retard en utilisant une deuxième résistance (R770) et une troisième résistance (R771) et à connecter un deuxième transistor (Q2) au dit premier transistor (Q1) par l'intermédiaire d'une résistance placée entre le collecteur dudit premier transistor (Q1) et la base dudit deuxième transistor (Q2) ;
• ladite première résistance (R1), qui est couplée au dit premier condensateur (C1) couplé à la charge, est connectée au collecteur dudit deuxième transistor (Q2) et ledit premier condensateur (C1) est chargé ; et
un deuxième condensateur (C2) est connecté entre la base et l'émetteur d'un troisième transistor (Q3) dans ledit deuxième circuit de commande, dans lequel la mise en route dudit troisième transistor (Q3) par application dudit signal logique fort sur ladite broche de contrôle (ON/OFF1) est retardée.
